**Europäisches Patentamt**

**European Patent Office**

**Office européen des brevets**

(19)

(11) Veröffentlichungsnummer: **0 016 251**
**B1**

(12)

# EUROPÄISCHE PATENTSCHRIFT

(45) Veröffentlichungstag der Patentschrift:
16.06.82

(21) Anmeldenummer: 79104498.5

(22) Anmeldetag: 14.11.79

(51) Int. Cl.³: **H 01 L 49/02, H 01 L 27/01,
H 05 K 3/16, H 01 B 5/14**

(54) **Elektronische Dünnschichtschaltung und deren Herstellungsverfahren.**

(30) Priorität: 22.02.79 DE 2906813

(43) Veröffentlichungstag der Anmeldung:
01.10.80 Patentblatt 80/20

(45) Bekanntmachung des Hinweises auf die Patenterteilung:
16.06.82 Patentblatt 82/24

(84) Benannte Vertragsstaaten:
**CH DE FR GB IT NL**

(56) Entgegenhaltungen:
**CITED DOCUMENTS (56):**
**DE-A-2157923**
**DE-A-2509912**
**DE-A-2746225**
**DE-B-1665571**
**DE-B-2105411**
**DE-B-2331586**
**DE-B-2606086**
**US-A-3487522**

(73) Patentinhaber: **ROBERT BOSCH GMBH, Postfach 50,
D-7000 Stuttgart 1 (DE)**

(72) Erfinder: **Gruner, Heiko, Dr. Dipl.-Phys., Nanetteweg 30,
D-7016 Gerlingen (DE)**
Erfinder: **Zimmermann, Georg, Dr. Dipl.-Chem.,
Gartenstrasse 58, D-7016 Gerlingen (DE)**

Elektronische Dünnschichtschaltung und deren Herstellungsverfahren

*Stand der Technik*

Die Erfindung geht aus von einer elektronischen Dünnschichtschaltung nach der Gattung des Hauptanspruchs. Aus der US-PS Nr. 3256588 ist bereits eine elektronische Dünnschichtschaltung dieser Art bekannt, bei der die Nickelschicht im Bereich des ersten Musters zur Bildung der Leiterbahnen und/oder Anschlusskontakte direkt auf die ventilmetallhaltige Schicht aufgebracht ist. Bei dieser Dünnschichtschaltung bereitet es Schwierigkeiten, die Nickelschicht gut haftend auf die ventilmetallhaltige Schicht aufzubringen. Wenn an der Nickelschicht ein Anschlussdraht durch Löten angebracht werden soll, besteht bei längeren Lötzeiten die Gefahr, dass sich die Nickelschicht in dem aufgebrachten Lot so weit löst, dass ihre Haftung an der ventilmetallhaltigen Schicht verloren geht.

*Vorteile der Erfindung*

Die erfindungsgemässe Dünnschichtschaltung mit den kennzeichnenden Merkmalen des Anspruchs 1 hat demgegenüber den Vorteil, dass die zwischen der Nickelschicht und der ventilmetallhaltigen Schicht angeordnete Übergangsschicht die Haftung der Nickelschicht auf der ventilmetallhaltigen Schicht erheblich verbessert. Wenn an der Nickelschicht im Bereich des ersten Musters ein Anschlussdraht durch Löten angebracht werden soll und/oder wenn in diesem Bereich die Nickelschicht durch Aufbringen einer Lotschicht ganzflächig verstärkt werden soll, kann das Lot nicht mehr bis zu der ventilmetallhaltigen Schicht vordringen, da die Übergangsschicht als Diffusionssperre wirkt.

*Zeichnung*

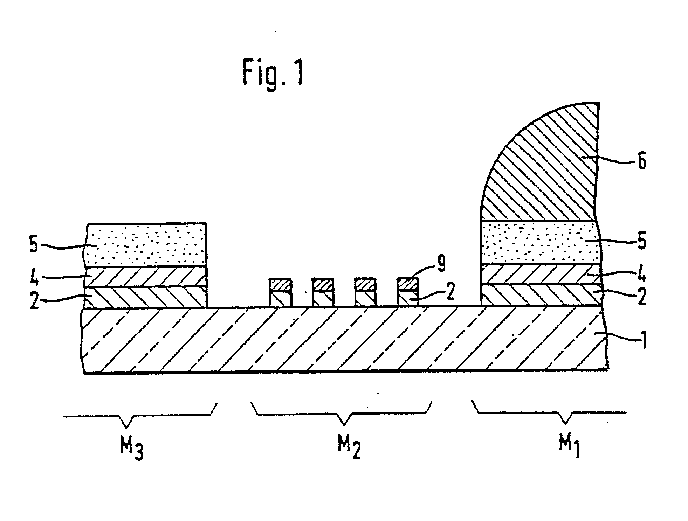

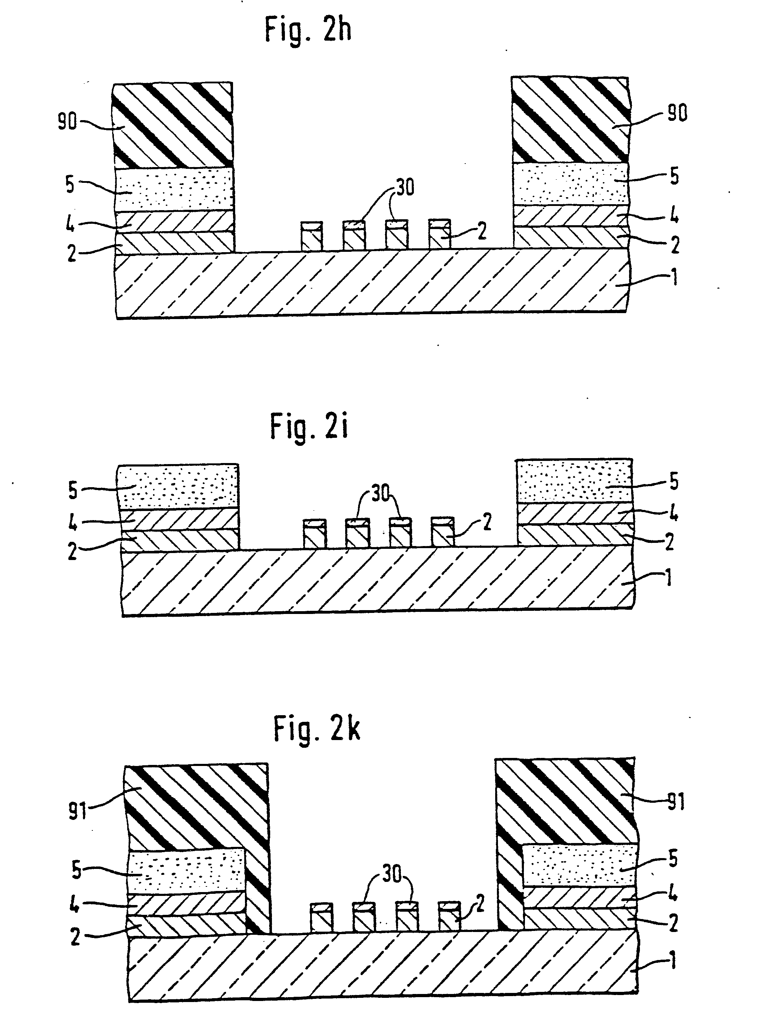

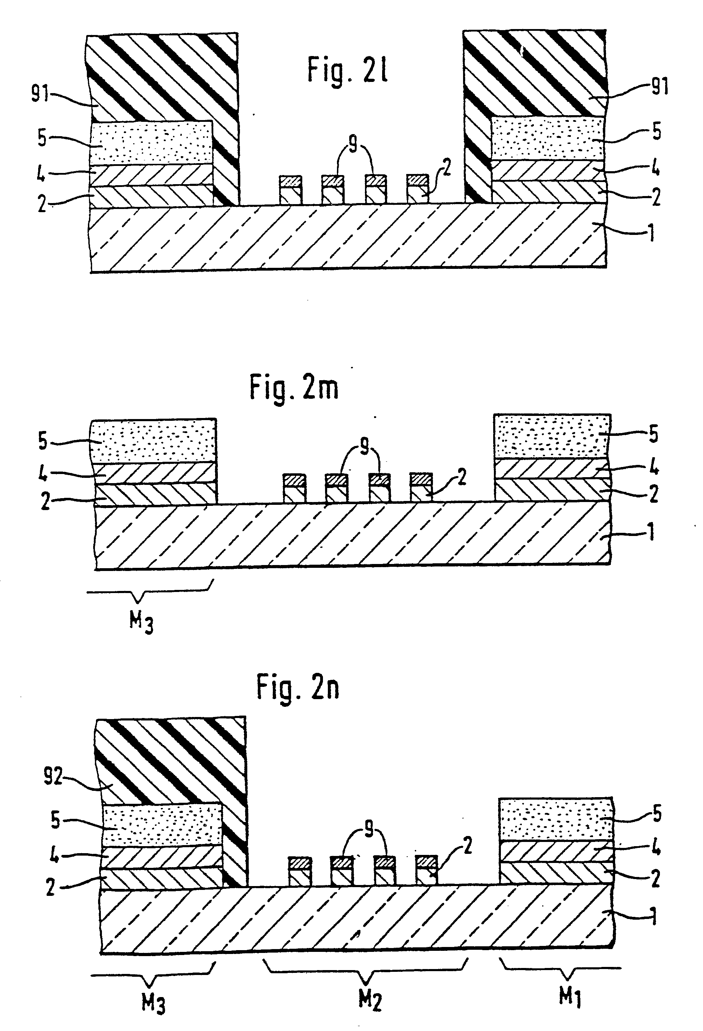

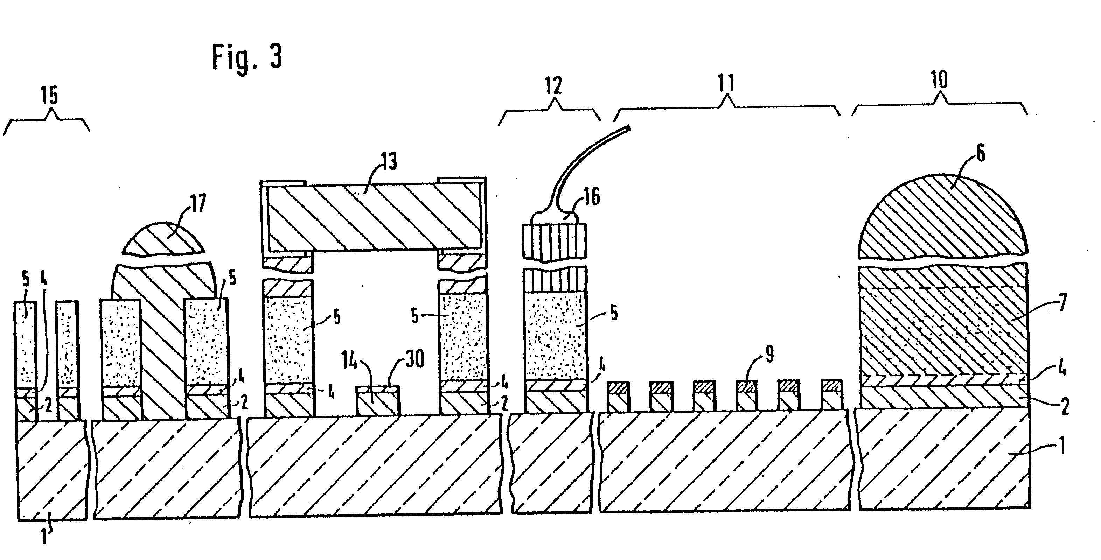

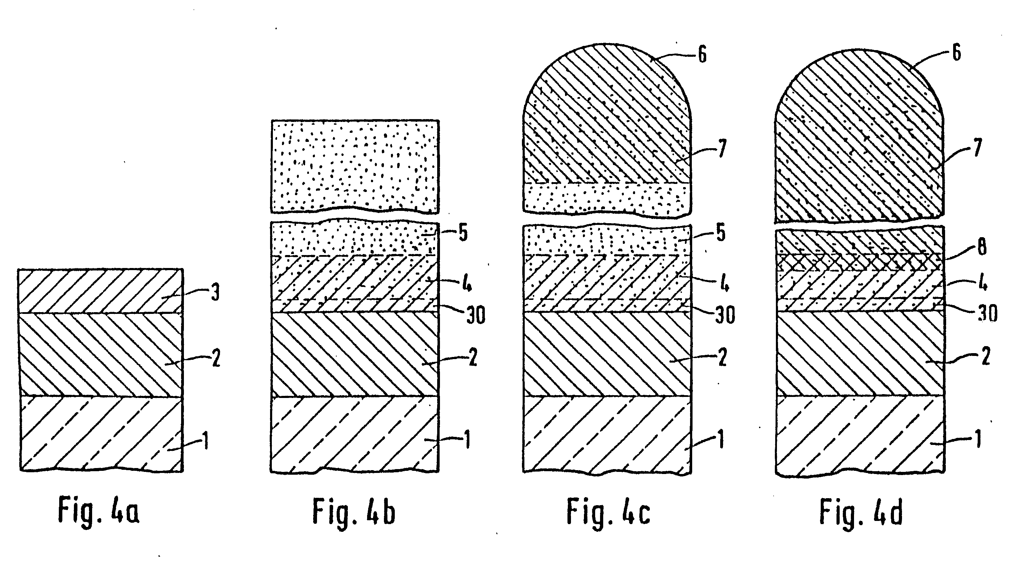

Ausführungsbeispiele der erfindungsgemässen Dünnschichtschaltung sind in der Zeichnung dargestellt und in der nachfolgenden Beschreibung näher erläutert. Es zeigen: Fig. 1 einen Teilschnitt durch eine einen temperaturunabhängigen und einen temperaturabhängigen Widerstand enthaltende Dünnschichtschaltung gemäss der Erfindung, Fig. 2a bis 2n die in Herstellung begriffene Dünnschichtschaltung nach Fig. 1 bei den verschiedenen erfindungsgemäss auszuführenden Verfahrensschritten, Fig. 3 ein Dünnschichthybrid als Anwendungsbeispiel einer elektronischen Dünnschichtschaltung gemäss der Erfindung, Fig. 4a bis 4d eine schematische Darstellung der Entstehung der Übergangsschicht und ihrer Wirkung als Lotsperrschicht.

*Beschreibung der Ausführungsbeispiele*

In Fig. 1 ist mit 1 eine isolierende Substratplatte bezeichnet, die beispielsweise aus Weichglas oder $Al_2O_3$-Keramik oder aus einer mit einer Isolationsschicht bedeckten Metallplatte, beispielsweise aus Federstahl oder Ferrit, besteht. Auf die Substratplatte 1 ist eine die Grundgeometrie des Schaltungsnetzwerks enthaltende Tantalschicht 2 aufgebracht. Die Schicht 2 kann auch aus Tantalnitrid oder Tantaloxinitrid ($TaO_xN_y$) oder aus einer Tantal-Aluminium-Legierung bestehen. Anstelle von Tantal kann sie als Hauptbestandteil auch ein anderes Ventilmetall, beispielsweise Niob, Aluminium, Zirkonium oder Hafnium, enthalten.

Die Tantalschicht 2 bildet ein erstes, ein zweites und ein drittes Muster der elektronischen Dünnschichtschaltung, von denen das erste Muster $M_1$ eine Leiterbahn und/oder einen Anschlusskontakt, das zweite Muster $M_2$ einen temperaturunabhängigen Widerstand und das dritte Muster $M_3$ einen temperaturabhängigen Widerstand definiert.

Im Bereich des ersten Musters $M_1$ ist die Tantalschicht 2 mit einer Übergangsschicht 4 bedeckt, die Tantal, Tantaloxid, Nickel, Nickeloxid und Mischphasen dieser Bestandteile enthält. Auf der Übergangsschicht 4 ist im Bereich des ersten Musters $M_1$ eine Nickelschicht 5 und auf der Nickelschicht 5 eine Lotschicht 6 angeordnet, die aus Blei-Zinn-Weichlot bestehen kann. Die Schichten 2, 4, 5 und 6 bilden im Bereich des ersten Musters $M_1$ die Leiterbahn und/oder den Anschlusskontakt. Die Lotschicht 6 kann dabei auch entfallen oder durch eine galvanisch aufgebrachte Verstärkungsschicht ersetzt sein.

Im Bereich des zweiten Musters $M_2$ bildet die Tantalschicht 2 den temperaturunabhängigen Widerstand und ist dabei mit einer Tantaloxidschicht 9 bedeckt.

Im Bereich des dritten Musters $M_3$ ist die Tantalschicht 2 wie im Bereich des ersten Musters $M_1$ mit der Übergangsschicht 4 und die Übergangsschicht 4 mit der Nickelschicht 5 bedeckt. Die Schichten 2, 4 und 5 bilden dabei im Bereich des dritten Musters $M_3$ den temperaturabhängigen Widerstand (Sensor).

Die im Bereich des zweiten Musters $M_2$ vorgesehene Tantaloxidschicht 9 kann auch durch eine Schicht 30 (vergleiche Fig. 2i und Fig. 3) ersetzt sein, deren Entstehung und Zusammensetzung weiter unten beschrieben wird.

Die Fig. 2a bis 2n zeigen die in Herstellung begriffene elektronische Dünnschichtschaltung nach Fig. 1 bei den verschiedenen erfindungsgemäss auszuführenden Verfahrensschritten.

Auf die isolierende Substratplatte 1 wird zuerst die Tantalschicht 2 als durchgehende Schicht durch Kathodenzerstäubung aufgebracht (Fig. 2a). Ihre Schichtdicke ergibt sich aus den beiden Aufgaben, welche dieser Tantalschicht zugeordnet sind. Sie ist einmal Haftvermittler zwischen der Substratplatte 1 und allen nachfolgenden Schichten. Zum anderen werden aus ihr im Bereich des zweiten Musters $M_2$ langzeitstabile, anodisch abgleichbare, weitgehend temperaturunabhängige Widerstände mit einem Temperaturkoeffizienten kleiner als 100 ppm/° C hergestellt, deren relative Widerstandsänderung aufgrund mechanischer Verformung etwa doppelt so gross ist wie die dadurch bewirkte relative Widerstandsverlängerung. Um beide Aufgaben erfüllen zu können, sollte diese Tantal-Haft- und Widerstandsschicht 2 einen Flächenwiderstand haben, der zwischen 20 und 200 $\Omega$, vorzugsweise bei 50 $\Omega$, liegt.

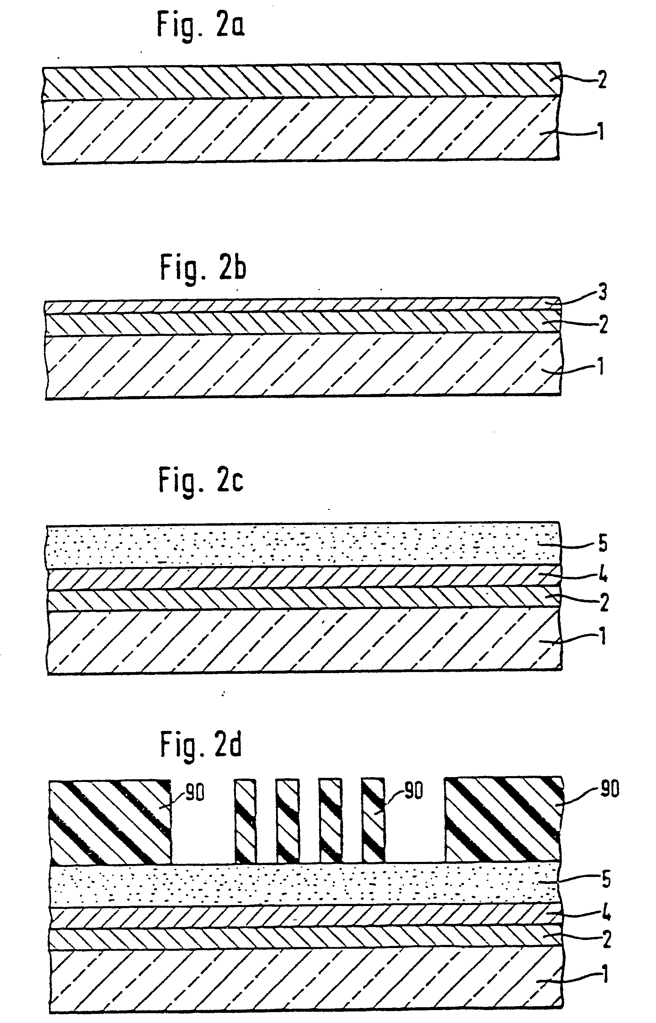

Die Tantalschicht 2 wird nun zunächst zur Bildung der Tantaloxidschicht 3 (Fig. 2b) an der freiliegenden Oberfläche oxidiert, vorzugsweise in einem Platten-Wasch- und Trocknungsprozess, bei welchem gleichzeitig alle Fremdpartikel von ihrer Oberfläche entfernt werden, welche zu Fehlstellen im weiteren Schichtaufbau führen können. Die Dicke der Tantaloxidschicht 3 wird mit Hilfe von Temperatur und Dauer der Plattentrocknung auf 3 bis 10 nm eingestellt, vorzugsweise auf 5 nm. Sie ist auf jeden Fall dicker als die natürliche Tantaloberflächenoxidschicht, welche sich bei Lagerung der Platten langsam ausbildet. Die Oxidschicht 3 kann auch durch andere Methoden hergestellt werden, beispielsweise mit Hilfe der anodischen Oxidation, wobei dann die gewünschte Dicke über die Abgleichparameter einstellbar ist.

In einem zweiten Aufstäubprozess wird nun die mit der geschlossenen Oxidschicht 3 bedeckte Tantalschicht 2 ganzflächig mit einer Nickelschicht 5 bedeckt, wobei die Aufstäubenergie so hoch gewählt wird, dass erstens die Tantalschicht 2 infolge der thermischen Belastung vorgealtert wird und so ihre Langzeitstabilität erhält, und dass es zweitens zu einer intermetallischen Diffusion von Nickelatomen in die Tantaloxidschicht 3 kommt, wobei sich über Reduktions- und Oxidationsprozesse eine Tantal, Tantaloxid, Nickel, Nikkeloxid und Mischphasen dieser Bestandteile enthaltende Übergangsschicht 4 (Fig. 2c) bildet, welche die Nickelschicht 5 ausgezeichnet auf der Tantalschicht 2 verankert und einen guten ohmschen Kontakt zwischen der Tantalschicht 2 und der Nickelschicht 5 herstellt.

Für den Fall, dass die Nickelschicht ohne Unterbrechung des Vakuums unmittelbar nach dem Aufstäuben der Tantalschicht aufgebracht werden kann, wird die notwendige Oberflächenoxidation der Tantalschicht in einer verzögerten Abkühlphase durch Reaktion mit dem Oxidations-Restgas hergestellt. Wenn dabei aus anderen Gründen die Energie der Nickelbestäubung so niedrig gehalten werden muss, dass die Nickeldiffusion in die Tantaloxidschicht noch nicht ausreichend erfolgt ist, kann der Diffusionsprozess und die Alterung der Tantalschicht auch in einem nachträglichen Temperprozess erfolgen.

Die Nickelschicht 5 erfüllt folgende Aufgaben:

Erstens ist sie im Bereich des dritten Musters $M_3$ (vergleiche Fig. 1) temperaturempfindliche Widerstandsschicht mit praktisch linearer Temperaturabhängigkeit des elektrischen Widerstandes (temperatursensor). Da der Temperaturkoeffizient mit steigender Schichtdicke zunimmt, der Widerstandswert sich aber bei gegebenen geometrischen Abmessungen und festgelegtem Längen-Breiten-Verhältnis der Widerstandsmäander umgekehrt proportional zur Schichtdicke verhält, ergibt sich die Dicke der Nickelschicht 5 zwangläufig aus den gestellten Forderungen nach R- und TKR-Wert des Temperatursensors. Ihr Flächenwiderstand liegt dann zwischen 0,1 und 5 $\Omega$, vorzugsweise bei 0,5 $\Omega$.

Zweitens kann die Nickelschicht 5 im Bereich des ersten Musters $M_1$ oder in Teilbereichen von ihm (vergleiche Fig. 3) Grundlage für galvanische Verstärkung sein, um auch aktive Bauelemente, beispielsweise Chip-Transistoren, mittels Bondverbindungen (Fig. 3) in die Dünnschichtschaltung einzubeziehen. Damit die galvanische Verstärkung gut abläuft und mit gleichmässiger Dicke auf allen galvanisch zu verstärkenden Bereichen der Nickelschicht abgeschieden wird, sollte der Flächenwiderstand der Nickelschicht unter 5 $\Omega$ liegen, vorzugsweise bei 0,5 $\Omega$.

Drittens kann die Nickelschicht 5 im Bereich des ersten Musters $M_1$ (vergleiche Fig. 1) oder in Teilbereichen von ihm (vergleiche Fig. 3) Lötpartner für die zur Erzielung genügend guter Leitfähigkeit notwendige Blei-Zinn-Weichlotschicht 6 sein, die sich vorzugsweise über alle Leiterbahnen, Verbindungsstellen und Anschlusskontakte erstreckt, also Hauptbestandteil dieser Bereiche $M_1$ selbst ist. Für die vorliegende Erfindung besonders bedeutend ist, dass die Nickelschicht 5 in ihrer Dicke nicht dem Lötprozess angepasst werden muss, sondern in ihrer Dicke den beiden anderen Aufgaben entsprechend optimiert ist, und dass sich trotzdem eine ausgezeichnete Lötstabilität des Schichtsystems ergibt. Das liegt an der erfindungsgemäss eingeführten Übergangsschicht 4, welche nur zu einem geringen Teil 8 im Blei-Zinn-Weichlot löslich ist (Fig. 4d). Wenn auf Grund von längeren Lötprozessen bei höheren Löttemperaturen sich die ganze Nickelschicht 5 im Weichlot aufgelöst hat (siehe Position 7 in Fig. 4d), beispielsweise beim Reparaturlöten in einer Schaltung, verhindert die Übergangsschicht 4, dass das Weichlot mit der Tantalschicht 2 in Kontakt kommt und sich tropfenförmig zusammenzieht. Gleichzeitig bleibt die Haftung der Lötschicht und der mit ihr verlöteten Bauelemente und Anschlussleiter unverändert gut, so dass auch für den Fall, dass das Weichlot bis zur Übergangsschicht 4 vorgedrungen ist, die Haftung durch die Bruchfestigkeit des verwendeten Substratmaterials oder des Lotes selbst begrenzt ist.

Die Aufstäubung der Nickelschicht 5 erfolgt bevorzugt unter Wasserstoffdotierung des Entladungsgases, um die Temperaturkoeffizienten der Nickelschicht zu steigern und weil dann die Lotbenetzung unerwartet so gut verläuft, dass ohne Schutzvergoldung und ohne Oberflächenaktivierung durch Anätzen oder Flussmittel gelötet werden kann.

Beim Ätzen der Schaltungsgeometrie (Fig. 2d bis Fig. 2f) wird folgendermassen verfahren:

Die Photolackmaske 90 lässt alle Bereiche frei, an denen die Oberfläche der Substratplatte 1 wieder freigelegt werden soll, wobei zur Kompensation der Tantalunterätzung unter die Lackkante alle schmalen Lackmaskenstege um etwa 2 $\mu$m verbreitert werden müssen.

Das Ätzen erfolgt in einem Zweischrittverfahren.

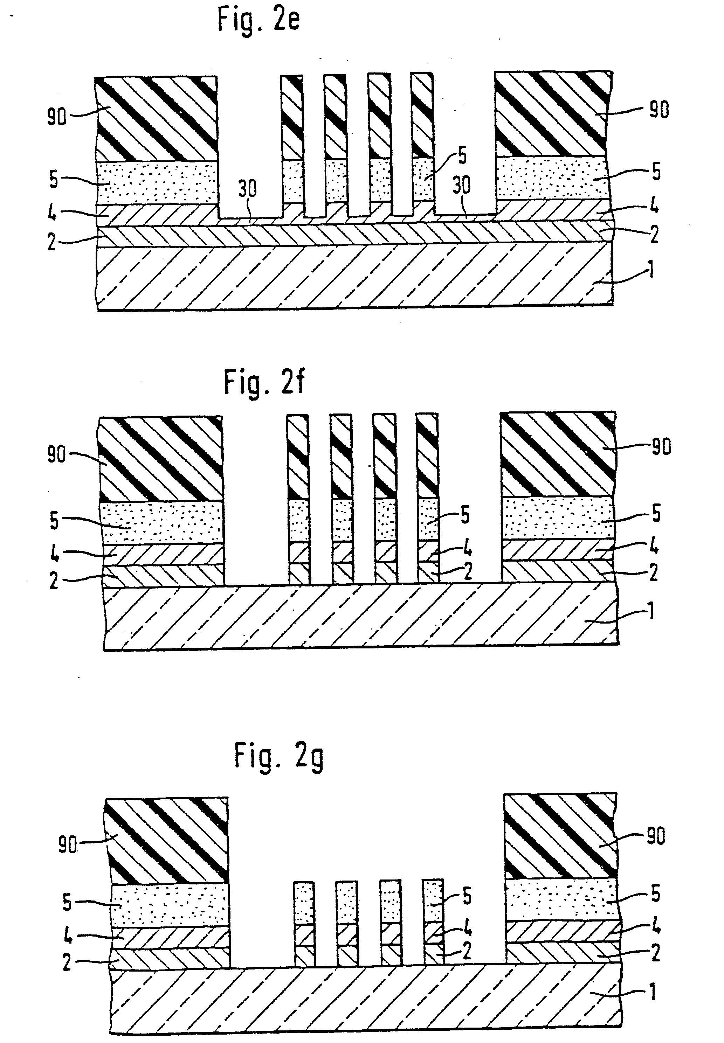

Im ersten Schritt (Fig. 2e) wird die Nickelschicht 5 und der grösste Teil der Übergangschicht 4 in einer Mischung von 190 g/l $(NH_4)_2S_2O_8$ mit 460 g/l $H_2SO_4$ praktisch ohne Unterätzung unter die Lackkante selektiv von der Tantalschicht 2 abgeätzt, wobei von der Übergangsschicht 4 ein kleiner Teil 30 (Fig. 2e) stehen bleibt.

Im zweiten Schritt (Fig. 2f) wird nach einer Zwischenwässerung der Rest 30 der Übergangsschicht 4 und die Tantalschicht 2 in einer Mischung von 190 g/l $(NH_4)_2S_2O_8$ mit 125 g/l HF, welche Nickel praktisch nicht angreift, abgeätzt. Die Nickelschicht 5 ist also Ätzmaske für die Tantaschicht 2, wodurch die Tantalunterätzung bezogen auf die Lackkante auf 1 $\mu$m beschränkt wird.

Beim Freiätzen der Tantalwiderstände (Fig. 2g bis Fig. 2i) wird wie folgt verfahren:

Aufgrund der unterwartet hohen Nickelätzgenauigkeit ist es nicht notwendig, für den zweiten selektiven Ätzprozess zur Freilegung der Tantalwiderstände die erste Ätzmaske 90 abzulösen und eine zweite Photoätzmaske durch eine zweite Lackbelegung, -belichtung und -entwicklung herzustellen, um so alle Nickelkanten und -flächen abzudecken, an denen keine selektive Nickelätzung erfolgen soll. Für die erfindungsgemäss durchgeführte zweite selektive Nickelätzung mit dem schon beim Ausätzen der Schaltungsgeometrie verwendeten selektiven Nickelätzmittel genügt vielmehr als Ätzmaske die erste Photolackmaske 90, welche nur in einer zweiten Belichtung und Entwicklung von den in Fig. 1 mit $M_2$ bezeichneten Stellen entfernt worden ist, an denen die Tantalschicht 2 freigelegt werden soll (Fig. 2g).

Führt man die Nickelätzung wie beschrieben mit dem erfindungsgemässen Ätzmittel durch, so ist auch bei langer Überätzung zum sicheren Freilegen der Tantalwiderstandsflächen die Nickelunterätzung unter die Lackkante praktisch vernachlässigbar. Sogar bei einer Ätzdauer, welche zehn mal so lang ist wie die normale Ätzzeit, bleibt die Unterätzung auf 4 $\mu$m beschränkt. Nach dem Freiätzen in der Fläche bildet sich an der Nickel-Lack-Ätzkante unerwartet eine Nickelpassivierungsschicht aus, welche ein Unterätzen verhindert.

Für den Abgleich der Tantalwiderstände durch anodische Oxidation im Bereich des zweiten Musters $M_2$ muss zuvor eine Abgleichmaske 91 (Fig. 2k) hergestellt werden. Hierbei wird wie folgt verfahren:

Nach dem Ablösen der ersten, für die Ätzprozesse verwendeten Photomaske 90 gemäss Fig. 2i muss vor dem zweiten Lackbelegen die Oberfläche wasserfrei sein, da sonst Lackhaftungsprobleme auftreten. Dazu werden die geätzten Platten im Ofen bei wenigstens 120° C etwa 30 min getrocknet, was aufgrund der Korrosionsstabilität der Nickelschicht 5 ohne Folgen für die Lotbenetzbarkeit bleibt und ausgezeichnete Lackhaftung auch auf den freigelegten Substratoberflächen garantiert. Durch Lackbelegung, -belichtung und -entwicklung wird dann die Abgleichmaske 91 hergestellt, wobei die Lackdicke sich aus der geforderten Durchschlagsfestigkeit ergibt.

Für die Gestaltung der Abgleichmaske 91 gelten folgende Bedingungen:

1. Um alle Nickelätzkanten vor einem Elektrolytangriff zu schützen, muss das Abgleichfenster in der Abgleichmaske 91 kleiner sein als an der selektiven Ätzmaske 90. Um wieviel kleiner es sein muss, ergibt sich aus der Wiederholgenauigkeit der Belichtungsapparatur, so dass ohne grossen Justieraufwand die Abgleichmaske 91 mit der geforderten Genauigkeit auf den geätzten Strukturen platziert werden kann. Für die Langzeitstabilität der Widerstände ist es unerheblich, dass so an jedem Ende eines Widerstandes ein geringes Stück ohne R-Abgleich bleibt. Diese Stücke der Widerstandsbahnen werden durch den beim selektiven Nickelätzen nicht gelösten Teil 30 der Übergangsschicht 4 ausreichend geschützt.

2. Die Abmessungen des Abgleichfensters können so gewählt werden, dass die durch ungleiche Stromdichteverteilung beispielsweise an einseitig angebundenen Widerständen verursachten Abgleichfehler zum grössten Teil kompensiert werden, indem von jedem individuellen Widerstand prozentual unterschiedlich grosse Flächen dem Anodisierungsprozess zugänglich gemacht werden und/oder zusätzliche Kontaktierungspunkte freigelegt werden.

Da alle freigelegten Tantalwiderstände an ihrer Oberfläche die beim selektiven Nickelätzprozess nicht gelösten Teile 30 der Übergangsschicht 4 besitzen, muss für die anodische Oxidation ein derartiger Elektrolyt und ein derartiges Abgleichverfahren gewählt werden, dass diese vor allem noch Nickeloxide enthaltende Schicht möglichst rasch im Elektrolyt gelöst wird und damit den Abgleichprozess nicht stört. Das ist bei $Na_2SO_4$ und/ oder $NH_4Cl$ enthaltenden Elektrolyten dann der Fall, wenn zunächst eine konstante Spannung zwischen 1 und 10 V an alle Widerstände angelegt wird, welche über den Lösungspotentialen von Nickel und von oxidischen Ta-Ni-Mischphasen im gewählten Elektrolyten liegt. Für 0,5 m $Na_2SO_4$ beträgt diese Spannung vorzugsweise 3 V. Dabei ist der Lösungsvorgang besonders rasch beendet, wenn der verwendete Generator eine hohe Strombegrenzung besitzt, so dass die für den Auflösungsprozess benötigte Ladung ungehindert fliessen kann. Gleichzeitig werden dann alle übrigen Nickelschichtrückstände von den Widerstandsbahnen abgelöst, welche z.B. aufgrund von Lackmaskenfehlern als Ätzrückstand beim selektiven Nickelätzen übrig geblieben sind.

Stehen für den Abgleichprozess nur Konstantstromquellen zur Verfügung, dann sollte zur Abkürzung des Auflösungsprozesses zunächst ein hoher Abgleichstrom gewählt werden, bis ein merklicher R-Abgleich erfolgt, beispielsweise bis zu 10% R-Anhebung. Der restliche Abgleich muss dann aber mit so geringer Stromdichte erfolgen, dass alle Widerstände der Schaltung nach dem Abgleich innerhalb der geforderten Toleranzgrenze liegen, wobei der R-Hub mittels hohem Strom schaltungsspezifisch gewählt werden kann.

Nach dem Widerstandsabgleich durch anodische Oxidation ist die Tantalschicht 2 im Bereich des zweiten Musters $M_2$ mit einer Tantaloxidschicht 9 bedeckt (Fig. 2l).

Die Abgleichmaske 91 wird nun abgelöst (Fig. 2m) und anschliessend auf die Nickelschicht 5 im Bereich des dritten Musters $M_3$ eine Maske 92 aus Lötstopplack aufgebracht (Fig. 2n).

Das in Fig. 2n dargestellte System 1, 2, 4, 5, 9, 92 wird nun in flüssiges Blei-Zinn-Weichlot eingetaucht. Das flüssige Lot benetzt die mit der Ventilmetalloxidschicht 9 behafteten Widerstandsbahnen 2 im Bereich des zweiten Musters $M_2$ und die mit der Maske 92 bedeckten Widerstandsbahnen 2, 4, 5 im Bereich des dritten Musters $M_3$ nicht. Die im Bereich des ersten Musters $M_1$ freiliegende Oberseite der Metallisierung 2, 4, 5 wird dagegen von dem flüssigen Lot unter Bildung einer Lotschicht 6 benetzt, so dass nach Ablösen der Lötstoppmaske 92 das in Fig. 1 dargestellte Gebilde entsteht, das die fertige elektronische Dünnschichtschaltung darstellt. Durch das Aufbringen der Lotschicht wird die elektrische Leitfähigkeit der Leiterbahnen und Anschlusskontakte erheblich erhöht.

Fig. 3 zeigt ein Dünnschichthybrid als Anwendungsbeispiel einer elektronischen Dünnschichtschaltung gemäss der Erfindung. Die Substratplatte ist wieder mit 1, die Tantalschicht mit 2 bezeichnet. Mit 9 ist eine durch anodische Oxidation gebildete Oxidschicht auf einem abgeglichenen Tantalwiderstand 11 bezeichnet. Ein mit einer Blei-Zinn-Weichlotschicht verstärkter Leiterbahnbereich ist bei 10 dargestellt. Bei 12 ist ein galvanisch verstärkter Leiterbahnteil mit Bondkontakt 16 dargestellt. Mit 13 ist ein im Reflow-Verfahren angelötetes Bauelement bezeichnet. Ein nicht abgeglichener Tantalwiderstand mit Schutzschicht 30 ist bei 14 dargestellt. Mit 15 ist ein temperaturabhängiger Widerstand (Sensor) bezeichnet, mit 17 ein eingedruckter CP-Widerstand (Conductive-Plastic-Widerstand).

In Fig. 4a bis 4d ist die Entstehung der Übergangsschicht 4 und ihre Wirkung als Lotsperrschicht schematisch dargestellt. Fig. 4a zeigt das Schichtsystem 2, 3 nach der Bildung der Tantaloxidschicht 3. Fig. 4b zeigt dasselbe Schichtsystem nach dem zusätzlichen Aufbringen der Nickelschicht 5. Man sieht, wie sich aus der Oxidschicht 3 die Übergangsschicht 4 gebildet hat. Mit 30 ist dabei derjenige Teil der Übergangsschicht 4 bezeichnet, der sich im selektiven Nickelätzmittel nicht löst und beim nicht abgeglichenen Tantalwiderstand (vergleiche Position 14 in Fig. 3) als Schutzschicht dient. Die Figuren 4c und 4d zeigen dasselbe Schichtsystem wie in Fig. 4b, jedoch nach dem Aufbringen der Blei-Zinn-Weichlotschicht 6. Fig. 4c zeigt dieses System bei kurzer Lötzeit und/oder niedriger Löttemperatur, Fig. 4d bei langer Lötzeit und/oder hoher Löttemperatur. Bei Fig. 4c hat sich nur ein Teil der Nickelschicht 5 im Lot 6 gelöst, bei Fig. 4d die ganze Nickelschicht 5. Ferner ist dort ein Teil 8 der Übergangsschicht 4 noch vom Lot angelöst worden. In den Figuren 4c und 4d ist mit 7 der im Lot 6 gelöste Teil der Nickelschicht bezeichnet.

**Ansprüche**

1. Elektronische Dünnschichtschaltung mit einer aus einem Isoliermaterial bestehenden Substratplatte (1), mit einer die Substratplatte (1) teilweise bedeckenden ventilmetallhaltigen Schicht (2), die ein erstes ($M_1$) und mindestens ein weiteres Muster ($M_2$, $M_3$) bildet, wobei das erste Muster ($M_1$) Leiterbahnen und/oder Anschlusskontakte und das bzw. die weiteren Muster ($M_2$, $M_3$) Schaltungselemente der elektronischen Dünnschichtschaltung definieren, mit einer im Bereich des ersten Musters ($M_1$) oberhalb der ventilmetallhaltigen Schicht (2) angeordneten Nickelschicht (5), dadurch gekennzeichnet, dass im Bereich des ersten Musters ($M_1$) zwischen der ventilmetallhaltigen Schicht (2) und der Nickelschicht (5) eine Übergangsschicht (4) angeordnet ist, die das Ventilmetall, Oxid des Ventilmetalls, Nickel, Nickeloxid und Mischphasen dieser Bestandteile enthält.

2. Elektronische Dünnschichtschaltung nach Anspruch 1, dadurch gekennzeichnet, dass mindestens auf Teile der Nickelschicht (5) im Bereich des ersten Musters ($M_1$) eine metallische Verstärkungsschicht aufgebracht ist.

3. Elektronische Dünnschichtschaltung nach Anspruch 2, dadurch gekennzeichnet, dass die metallische Verstärkungsschicht mindestens teilweise eine Lotschicht, vorzugsweise eine Weichlotschicht (6) ist.

4. Elektronische Dünnschichtschaltung nach Anspruch 2, dadurch gekennzeichnet, dass die metallische Verstärkungsschicht mindestens teilweise eine galvanisch aufgebrachte Schicht ist.

5. Elektronische Dünnschichtschaltung nach mindestens einem der Ansprüche 1 bis 4, dadurch gekennzeichnet, dass die ventilmetallhaltige Schicht (2) als weiteres Muster ein zweites Muster ($M_2$) enthält, das mindestens einen im wesentlichen temperaturunabhängigen Widerstand bildet.

6. Elektronische Dünnschichtschaltung nach mindestens einem der Ansprüche 1 bis 5, dadurch gekennzeichnet, dass die ventilmetallhaltige Schicht (2) als weiteres Muster ein drittes Muster ($M_3$) enthält, das mindestens einen temperaturabhängigen Widerstand (Sensor) definiert, dass im Bereich dieses dritten Musters ($M_3$) auf der ventilmetallhaltigen Schicht (2) die Übergangsschicht (4) und auf der Übergangsschicht (4) die Nickelschicht (5) angeordnet ist, wobei die Nickelschicht (5) im Bereich dieses dritten Musters ($M_3$) den bzw. die temperaturabhängigen Widerstände (Sensoren) bildet.

7. Elektronische Dünnschichtschaltung nach mindestens einem der Ansprüche 1 bis 6, dadurch gekennzeichnet, dass der Flächenwiderstand der ventilmetallhaltigen Schicht (2) zwischen 20 und 200 $\Omega$ liegt.

8. Elektronische Dünnschichtschaltung nach Anspruch 7, dadurch gekennzeichnet, dass der Flächenwiderstand der ventilmetallhaltigen Schicht (2) bei 50 $\Omega$ liegt.

9. Elektronische Dünnschichtschaltung nach mindestens einem der Ansprüche 1 bis 8, dadurch gekennzeichnet, dass der Flächenwiderstand der Nickelschicht (5) zwischen 0,1 und 5 $\Omega$ liegt.

10. Elektronische Dünnschichtschaltung nach Anspruch 9, dadurch gekennzeichnet, dass der Flächenwiderstand der Nickelschicht (5) bei 0,5 Ω liegt.

11. Verfahren zur Herstellung einer elektronischen Dünnschichtschaltung nach einem der Ansprüche 1 bis 10, dadurch gekennzeichnet, dass auf die Substratplatte (1) durch Kathodenzerstäubung zuerst eine durchgehende ventilmetallhaltige Schicht (2) aufgebracht wird, dass man dann auf der ventilmetallhaltigen Schicht (2) ganzflächig eine Schicht (3) aus Ventilmetalloxid aufwachsen lässt, dass dann auf die Ventilmetalloxidschicht (3) durch Kathodenzerstäubung eine durchgehende Nickelschicht (5) aufgebracht wird, wobei die Aufstäubenergie so hoch gewählt wird, dass es zu einer intermetallischen Diffusion von Nickelatomen in die Ventilmetalloxidschicht (3) kommt, wobei sich über Reduktions- und Oxidationsprozesse aus der Ventilmetalloxidschicht (3) die Übergangsschicht (4) bildet, und dass dann aus dem so auf der Substratplatte (1) gebildeten durchgehenden Dreischichtsystem (2, 4, 5) die aus den verschiedenen Mustern ($M_1$, $M_2$, $M_3$) bestehende Grundgeometrie der elektronischen Dünnschichtschaltung ausgeätzt wird.

12. Verfahren nach Anspruch 11, dadurch gekennzeichnet, dass man die Ventilmetalloxidschicht (3) auf der durchgehenden ventilmetallhaltigen Schicht (2) in einer Dicke zwischen 3 und 10 nm aufwachsen lässt.

13. Verfahren nach Anspruch 12, dadurch gekennzeichnet, dass man die Ventilmetalloxidschicht (3) in einer Dicke von 5 nm aufwachsen lässt.

14. Verfahren nach einem der Ansprüche 11 bis 13, dadurch gekennzeichnet, dass zur Ausätzung der Grundgeometrie der elektronischen Dünnschichtschaltung auf die Nickelschicht (5) eine Photolackmaske (90) aufgebracht wird, die alle Bereiche freilässt, an denen die Oberfläche der Substratplatte (1) wieder freigelegt werden soll, dass dann innerhalb des von der Photolackmaske (90) freigelassenen Bereichs die Nickelschicht (5) und der grösste Teil der Übergangsschicht (4) in einem Nickelätzmittel, das aus einer Mischung von 190 g/l $(NH_4)_2S_2O_8$ und 460 g/l $H_2SO_4$ besteht, selektiv abgeätzt wird (Fig. 2e) und dass dann der auf der ventilmetallhaltigen Schicht (2) noch verbliebene restliche Teil (30) der Übergangsschicht (4) und die ventilmetallhaltige Schicht (2) in einem Ventilmetallätzmittel, das aus einer Mischung von 190 g/l $(NH_4)_2S_2O_8$ und 125 g/l HF besteht, abgeätzt wird (Fig. 2f).

15. Verfahren nach einem der Ansprüche 11 bis 14 zur Herstellung einer elektronischen Dünnschichtschaltung, bei der die ventilmetallhaltige Schicht (2) als weiteres Muster ein zweites Muster ($M_2$) enthält, das mindestens einen im wesentlichen temperaturunabhängigen Widerstand bildet, dadurch gekennzeichnet, dass, nachdem die Grundgeometrie der elektronischen Dünnschichtschaltung ausgeätzt worden ist, im Bereich des zweiten Musters ($M_2$) die Nickelschicht (5) und die Übergangsschicht (4) bis auf einen nicht löslichen Teil (30) in einem Nickelätzmittel, das aus einer Mischung von 190 g/l $(NH_4)_2S_2O_8$ und 460 g/l $H_2SO_4$ besteht, selektiv von der ventilmetallhaltigen Schicht (2) abgeätzt wird (Fig. 2h).

16. Verfahren nach Anspruch 15, dadurch gekennzeichnet, dass zum selektiven Abätzen der Nickelschicht (5) und des grössten Teils der Übergangsschicht (4) im Bereich des zweiten Musters ($M_2$) die bereits zum Ausätzen der Grundgeometrie der elektronischen Dünnschichtschaltung verwendete Photolackmaske (90) verwendet wird, dass jedoch diese Maske (90) in einer zweiten Belichtung und Entwicklung im Bereich des zweiten Musters ($M_2$) entfernt wird (Fig. 2g).

17. Verfahren nach Anspruch 15 oder 16, dadurch gekennzeichnet, dass, nachdem die Nickelschicht (5) und der grösste Teil der Übergangsschicht (4) im Bereich des zweiten Musters ($M_2$) abgeätzt worden ist, in diesem Bereich der im Nickelätzmittel nicht gelöste Teil (30) der Übergangsschicht (4) und die ventilmetallhaltige Schicht (2) in einem Elektrolyten unter Stromdurchgang behandelt wird, wobei zuerst der im Nickelätzmittel nicht gelöste Teil (30) der Übergangsschicht (4) im Elektrolyten gelöst wird und anschliessend auf der so freigelegten Oberfläche der ventilmetallhaltigen Schicht (2) eine Ventilmetalloxidschicht (9) durch anodische Oxidation gebildet wird (Fig. 2l).

18. Verfahren nach Anspruch 17, dadurch gekennzeichnet, dass für die anodische Oxidation der temperaturunabhängigen Widerstände ein Elektrolyt verwendet wird, der $Na_2SO_4$ und/oder $NH_4Cl$ enthält, und dass an alle temperaturunabhängigen Widerstände zunächst eine konstante Spannung zwischen 1 und 10 V so lange angelegt wird, bis sich der im Nickelätzmittel nicht gelöste Teil (30) der Übergangsschicht (4) in dem Elektrolyten vollständig aufgelöst hat.

19. Verfahren nach mindestens einem der Ansprüche 11 bis 18, dadurch gekennzeichnet, dass mindestens auf Teile der Nickelschicht (5) im Bereich des ersten Musters ($M_1$) eine metallische Verstärkungsschicht aufgebracht wird.

20. Verfahren nach Anspruch 19, dadurch gekennzeichnet, dass die metallische Verstärkungsschicht mindestens teilweise aus einer galvanisch aufgebrachten Schicht besteht.

21. Verfahren nach Anspruch 19, dadurch gekennzeichnet, dass die metallische Verstärkungsschicht mindestens teilweise aus einer Weichlotschicht (6) besteht, die durch Eintauchen des gesamten Systems in flüssiges Weichlot aufgebracht wird.

22. Verfahren nach mindestens einem der Ansprüche 11 bis 21, dadurch gekennzeichnet, dass auf Teile der Nickelschicht (5) im Bereich des dritten Musters ($M_3$) und auf freigelegte Teile der Substratoberfläche ein Conductive-Plastic (CP)-Widerstand (17) aufgedruckt wird (Fig. 3).

## Claims

1. An electronic thin-film circuit comprising a substrate plate (1) consisting of an insulating material, a valve metalcontaining layer (2) partially covering the substrate plate (1) and which forms

a first ($M_1$) and at least a second pattern ($M_2$, $M_3$), wherein the first pattern ($M_1$) defines conductor strips and/or terminal contacts and the further pattern or patterns ($M_2$, $M_3$) define circuit elements of the electronic thin-film circuit, and comprising a nickel layer (5) arranged in the region of the first pattern ($M_1$) above the valve metal containing layer (2), characterised in that, a junction layer (4), which includes the valve metal, oxide the valve metal, nickel, nickel oxide and mixed phases of these components, is arranged in the region of the first pattern ($M_1$) between the valve metal containing layer (2) and the nickel layer (5).

2. An electronic thin-film circuit according to claim 1, characterised in that, a metallic reinforcing layer is applied at least to portions of the nickel layer (5) in the region of the first pattern ($M_1$).

3. An electronic thin-film circuit according to claim 2, characterised in that, the metallic reinforcing layer is at least partially a solder layer, preferably a soft solder layer (6).

4. An electronic thin-film circuit according to claim 2, characterised in that, the metallic reinforcing layer is at least partially a galvanically applied layer.

5. An electronic thin-film circuit according to at least one of claims 1 to 4, characterised in that, the valve metal containing layer (2) includes a second pattern ($M_2$) in the form of a further pattern which forms at least one resistor substantially independent of temperature.

6. An electronic thin-film circuit according to at least one of claims 1 to 5, characterised in that, the valve metal containing layer (2) includes a third pattern ($M_3$) in the form of a further pattern which defines at least one temperature dependent resistor (sensor), that the junction layer (4) is arranged on the valve metal containing layer (2) in the region of the said third pattern ($M_3$) and the nickel layer (5) is arranged on the junction layer (4), wherein the nickel layer (5) in the region of the said third pattern ($M_3$) forms the temperature dependent resistor or resistors (sensors).

7. An electronic thin-film circuit according to at least one of claims 1 to 6, characterised in that, the surface resistance of the valve metal containing layer (2) lies between 20 and 200$\Omega$.

8. An electronic thin-film circuit according to claim 7, characterised in that, the surface resistance of the valve metal containing layer (2) lies at 50$\Omega$.

9. An electronic thin-film circuit according to at least one of claims 1 to 8, characterised in that, the surface resistance of the nickel layer (5) lies between 0.1 and 5$\Omega$.

10. An electronic thin-film circuit according to claim 9, characterised in that surface resistance of the nickel layer (5) lies at 0.5$\Omega$.

11. A method of producing an electronic thin-film circuit according to one of claims 1 to 10, characterised in that, a complete valve metal containing layer (2) is first of all applied to the substrate plate (1) by cathode vapour deposition, that a layer (3) of valve metal oxide is then caused to grow on the valve metal including layer (2) over the whole area, that a complete nickel layer (5) is then applied to the valve metal oxide layer (3) by cathode vapour deposition wherein the deposition energy is selected high enough for an intermetallic diffusion of nickel atoms into the valve metal oxide layer (3) to be produced, whereby the junction layer (4) is formed from the valve metal oxide layer (3) by reduction and oxidation processes, and that the basic geometry of the electronic thin-film circuit consisting of the various patterns ($M_1$, $M_2$, $M_3$) is then etched from the complete three-layer system (2, 4, 5,) formed on the substrate plate (1).

12. A method according to claim 11, characterised in that, the valve metal oxide layer (3) is caused to grow on the complete valve metal containing layer (2) to a thickness between 3 and 10 nm.

13. A method according to claim 12, characterised in that, the valve metal oxide layer (3) is caused to grow to a thickness of 5 nm.

14. A method according to one of claims 11 to 13, characterised in that, a photoresist mask (90) is applied to the nickel layer (5) for etching the basic geometry of the electronic thin-film circuit and which uncovers all regions at which the surface of the substrate plate (1) is to be uncovered once again, that the nickel layer (5) and the greater portion of the junction layer (4) is then selectively etched away within the uncovered region of the photoresist mask (90) in a nickel etching agent which consists of a mixture of 190 g/l $(NH_4)_2S_2O_8$ and 460 g/l $H_2SO_4$ (Figure 2e), and that the portion (30) of the junction layer (4) still remaining on the valve metal containing layer (2) and the valve metal containing layer (2) is then etched away in a valve metal etching agent which consists of a mixture of 190 g/l $(NH_4)_2S_2O_8$ and 125 g/l HF (Figure 2f).

15. A method according to one of claims 11 to 14 for the production of an electronic thin-film circuit in which the valve metal containing layer (2) includes a second pattern ($M_2$) in the form of a pattern which forms at least one resistor substantially independent of temperature, characterised in that, after the basic geometry of the electronic thin-film circuit has been etched away, the nickel layer (5) and the junction layer (4) in the region of the second pattern ($M_2$) is selectively etched away from the valve metal containing layer (2) up to an insoluble portion (30) in a nickel etching agent which consists of a mixture of 190 g/l $(NH_4)_2S_2O_8$ and 460 g/l $H_2SO_4$ (Figure 2h).

16. A method according to claim 15, characterised in that, the photoresist mask (90) already used for etching the basic geometry of the electronic thin-film circuit is used for the selective etching away of the nickel layer (5) and of the greater portion of the junction layer (4) in the region of the second pattern ($M_2$), that the said mask (90) is, however, removed in the region of the second pattern ($M_2$) by a second exposure and development (Figure 2g).

17. A method according to claim 15 or 16, characterised in that, after the nickel layer (5) and the greater portion of the junction layer (4) has been etched away in the region of the second pattern ($M_2$), the portion (30) of the junction layer (4) not dissolved in the nickel etching agent in the said region and the valve metal containing layer (2) is treated in an electrolyte by passing current therethrough, whereby the portion (30) of the junction layer (4) is first of all dissolved in the nickel etching agent and a valve metal oxide layer (9) is then formed on the thus exposed surface of the valve metal containing layer (2) by anodic oxidation (Figure 21).

18. A method according to claim 17, characterised in that, for the anodic oxidation of the resistors independent of temperature, an electrolyte is used which includes $Na_2SO_4$ and/or $NH_4Cl$ and that a constant voltage between 1 à 10 V is then applied to all resistors which are independent of temperature until the portion (30) of the junction layer (4) not dissolved in the nickel etching agent is completely dissolved in the electrolyte.

19. A method according to at least one of claims 11 to 18, characterised in that, a metalic reinforcing layer is applied at least to portions of the nickel layer (5) in the region of the first pattern ($M_1$).

20. A method according to claim 19, characterised in that, the metallic reinforcing layer consists at least partially of a galvanically applied layer.

21. A method according to claim 19, characterised in that, the metallic reinforcing layer consists at least partially of a soft solder layer (6) which is applied by dipping the entire system in liquid soft solder.

22. A method according to at least one of claims 11 to 21, characterised in that, a conductive plastic (CP) resistor (17) is printed on portions of the nickel layer (5) in the region of the third pattern ($M_3$) and on exposed portions of the substrate surface (Figure 3).

## Revendications

1. Circuit électronique à couche mince avec une plaque de substrat (1) constituée en une matière isolante, avec une couche (2) contenant un métal de valve recouvrant partiellement la plaque de substrat (1), formant un premier ($M_1$) et au moins un second modèles ($M_2$, $M_3$), le premier modèle ($M_1$) définissant des pistes conductrices et/ou des contacts de connexion et le ou les autres modèles ($M_2$, $M_3$) définissant des composants du circuit électronique à couche mince de nickel (5) disposée dans le domaine du premier modèle ($M_1$) au-dessus de la couche (2) contenant un métal de valve, caractérisé en ce que dans le domaine du premier modèle ($M_1$) est disposée, entre la couche (2) contenant un métal de valve et la couche de nickel (5), une couche de transition (4) qui contient le métal de valve, l'oxyde du métal de valve, du nickel, de l'oxyde de nickel et des phases de mélange de ces éléments constituants.

2. Circuit électronique à couche mince selon la revendication 1, caractérisé en ce qu'une couche de renforcement métallique est disposée au moins sur des parties de la couche de nickel (5) dans le domaine du premier modèle ($M_1$).

3. Circuit électronique à couche mince selon la revendication 2, caractérisé en ce que la couche de renforcement métallique est au moins partiellement une couche de soudure, de préférence une couche de soudure tendre (6).

4. Circuit électronique à couche mince selon la revendication 2, caractérisé en ce que la couche de renforcement métallique est au moins partiellement une couche déposée par galvanoplastie.

5. Circuit électronique à couche mince selon au moins l'une des revendications 1 à 4, caractérisé en ce que la couche (2) contenant un métal de valve contient, en tant qu'autre modèle, un second modèle ($M_2$) qui forme au moins une résistance sensiblement indépendante de la température.

6. Circuit électronique à couche mince selon au moins l'une des revendications 1 à 5, caractérisé en ce que la couche (2) contenant un métal de valve contient, en tant qu'autre modèle, un troisième modèle ($M_3$) définissant au moins une résistance fonction de la température (détecteur), en ce que dans le domaine de ce troisième modèle ($M_3$) est disposée sur la couche (2) contenant un métal de valve, la couche de transition (4) et sur la couche de transition (4) la couche de nickel (5), la couche de nickel (5) formant dans le domaine de ce troisième modèle ($M_3$) la résistance fonction de la température (détecteurs).

7. Circuit électronique à couche mince selon au moins l'une des revendications 1 à 6, caractérisé en ce que la résistance superficielle de la couche (2) contenant un métal de valve se trouve entre 20 et 200$\Omega$.

8. Circuit électronique à couche mince selon la revendication 7, caractérisé en ce que la résistance superficielle de la couche (2) contenant un métal de valve est de 50$\Omega$.

9. Circuit électronique à couche mince, selon au moins l'une des revendications 1 à 8, caractérisé en ce que la résistance superficielle de la couche de nickel (5) se trouve entre 0,1 et 5$\Omega$.

10. Circuit électronique à couche mince selon la revendication 9, caractérisé en ce que la résistance superficielle de la couche de nickel (5) est de 0,5$\Omega$.

11. Procédé pour fabriquer un circuit électronique à couche mince selon l'une des revendications 1 à 10, caractérisé en ce qu'une couche continue (2) contenant un métal de valve est d'abord déposée par pulvérisation cathodique sur la plaque de substrat (1), en ce qu'on fait ensuite croître, sur toute la surface (2) contenant un métal de valve, une couche (3) en oxyde de métal de valve, en ce qu'une couche de nickel continue (5) est ensuite déposée par pulvérisation cathodique sur la couche (3) d'oxyde de métal de valve, l'énergie de pulvérisation étant choisie suffisamment grande pour qu'il y ait une diffusion intermétallique des atomes de nickel dans la couche (3) d'oxyde de métal de valve, la couche de transition (4) se formant par des processus de réduction et d'oxydation à partir de la couche (3) d'oxyde de métal de valve, et en ce qu'ensuite, la géométrie de base du circuit électronique à couche mince, constituée par les différents modèles ($M_1$, $M_2$, $M_3$), est gravée chimiquement dans le système continu à trois couches (2, 4, 5) ainsi formé sur la plaque de substrat (1).

12. Procédé selon la revendication 11, caractérisé en ce qu'on fait croître la couche (3) d'oxyde de métal de valve sur la couche continue (2) contenant un métal de valve dans une épaisseur comprise entre 3 et 10 nm.

13. Procédé selon la revendication 12, caractérisé en ce qu'on fait croître la couche (3) d'oxyde de métal de valve dans une épaisseur de 5 nm.

14. Procédé selon l'une des revendications 11 à 13, caractérisé en ce que pour graver chimiquement la géométrie de base du circuit électronique à couche mince sur la couche de nickel (5), on dépose un masque en photolaque (90) qui dégage toutes les zones sur lesquelles la plaque de substrat (1) doit être dégagée, en ce qu'on élimine ensuite chimiquement de façon sélective, par le masque en photolaque (90), la couche de nickel (5) et la grande partie de la couche de transition (4), dans un agent d'attaque du nickel, constitué par un mélange de 190 g/l de $(NH_4)_2S_2O_8$ et de 460 g/l de $H_2SO_4$ (fig. 2e) et en ce qu'on élimine ensuite chimiquement la partie encore restante (30) sur la couche (2) contenant un métal de valve de la couche de transition (4), et la couche (2) contenant un métal de valve, dans un agent d'attaque du métal de valve, constitué par un mélange de 190 g/l de $(NH_4)_2S_2O_8$ et de 125 g/l de HF (fig. 2f).

15. Procédé selon l'une des revendications 11 à 14, pour fabriquer un circuit électronique à couche mince, dans lequel la couche (2) contenant un métal de valve contient, en tant qu'autre modèle ($M_2$) qui forme au moins une résistance sensiblement indépendante de la température, caractérisé en ce que, après que la géométrie de base du circuit électronique en couche mince a été gravée chimiquement, on élimine chimiquement de façon sélective de la couche (2) contenant un métal de valve, dans le domaine du second modèle ($M_2$), la couche de nickel (5) et la couche de transition (4) à l'exception d'une partie non soluble (30), dans un agent d'attaque du nickel, constitué par un mélange de 190 g/l de $(NH_4)_2S_2O_8$ et de 460 g/l de $H_2SO_4$ fig. 2h).

16. Procédé selon la revendication 15, caractérisé en ce que pour l'élimination chimique sélective de la couche de nickel (5), et de la plus grande partie de la couche de transition (4), dans le domaine du second modèle ($M_2$), on utilise le masque en photolaque (90) déjà utilisé pour graver chimiquement la géométrie de base du circuit électronique à couche mince, en ce que ce masque (90) est cependant éliminé par une seconde exposition et un développement dans le domaine du second modèle ($M_2$) (fig. 2g).

17. Procédé selon l'une des revendications 15 ou 16, caractérisé en ce que, après que la couche de nickel (5) et la plus grande partie de la couche de transition (4) ont été éliminées chimiquement dans le domaine du second modèle ($M_2$), on traite dans ce domaine dans un électroyte par passage du courant, la partie (30) de la couche de transition (4) non dissoute dans l'agent d'attaque du nickel et la couche (2) contenant un métal de valve, la partie (30) de la couche de transition (4) non dissoute dans l'agent d'attaque du nickel étant d'abord dissoute dans l'électrolyte, et une couche (9) d'oxyde de métal de valve étant ensuite formée par oxydation anodique sur la surface ainsi dégagée de la couche (2) contenant un métal de valve (fig. 21).

18. Procédé selon la revendication 17, caractérisé en ce que pour l'oxydation anodique des résistances indépendantes de la température, on utilise un électrolyte qui contient $Na_2SO_4$ et/ou $NH_4Cl$, et en ce qu'on applique d'abord, à toutes les résistances indépendantes de la température, une tension constante comprise entre 1 et 10 V jusqu'à ce que la partie (30) de la couche de transition (4) non dissoute dans l'agemt d'attaque du nickel soit complètement dissoute dans l'électrolyte.

19. Procédé selon au moins l'une des revendications 11 à 18, caractérisé en ce qu'on dépose une couche de renforcement métallique au moins sur des parties de la couche de nickel (5), dans le domaine du premier modèle ($M_1$).

20. Procédé selon la revendication 19, caractérisé en ce que la couche de renforcement métallique est constituée au moins partiellement par une couche déposée par galvanoplastie.

21. Procédé selon la revendication 19, caractérisé en ce que la couche de renforcement métallique est constituée, au moins partiellement, par une couche de soudure tendre (6) qui est déposée par immersion de l'ensemble du système dans une soudure tendre liquide.

22. Procédé selon au moins l'une des revendications 11 à 21, caractérisé en ce qu'une résistance (17) conductrice plastique (CP) est imprimée sur des parties de la couche de nickel (5) dans le domaine du troisième modèle ($M_3$) et sur des parties dégagées de la surface du substrat (fig. 3).

# Fig. 1

0 016 251

# Fig. 2a

# Fig. 2b

# Fig. 2c

# Fig. 2d

13

0 016 251

## Fig. 2e

## Fig. 2f

## Fig. 2g

## Fig. 2h

## Fig. 2i

## Fig. 2k

Fig. 2l

Fig. 2m

Fig. 2n

Fig. 3

0 016 251

Fig. 4a     Fig. 4b     Fig. 4c     Fig. 4d

0 016 251